Europäisches Patentamt

European Patent Office

Office européen des brevets

(19)

(11) **EP 0 885 487 B1**

(12) **EUROPÄISCHE PATENTSCHRIFT**

(45) Veröffentlichungstag und Bekanntmachung des Hinweises auf die Patenterteilung:
**12.01.2000 Patentblatt 2000/02**

(21) Anmeldenummer: **96945531.0**

(22) Anmeldetag: **23.10.1996**

(51) Int Cl.$^7$: **H03L 7/099**, H04L 27/20

(86) Internationale Anmeldenummer:
**PCT/DE96/02032**

(87) Internationale Veröffentlichungsnummer:
**WO 97/33374 (12.09.1997 Gazette 1997/39)**

(54) **VERFAHREN UND ANORDNUNG ZUR ABLEITUNG VON MEHREREN TAKTSIGNALEN**

PROCESS AND DEVICE FOR GENERATING A PLURALITY OF DERIVED CLOCK SIGNALS

PROCEDE ET DISPOSITIF DE GENERATION D'UNE PLURALITE DE SIGNAUX D'HORLOGE DERIVES

(84) Benannte Vertragsstaaten:
**CH DE FR GB IT LI SE**

(30) Priorität: **06.03.1996 DE 19608666**

(43) Veröffentlichungstag der Anmeldung:
**23.12.1998 Patentblatt 1998/52**

(73) Patentinhaber: **ROBERT BOSCH GMBH**
**70442 Stuttgart (DE)**

(72) Erfinder: **AUER, Erich**
**D-74354 Besigheim (DE)**

(56) Entgegenhaltungen:
**EP-A- 0 492 588       DE-A- 3 919 530**
**FR-A- 2 671 246**

• **PATENT ABSTRACTS OF JAPAN vol. 018, no. 425 (E-1590), 9.August 1994 & JP 06 132816 A (SONY TEKTRONIX CORP), 13.Mai 1994, & US 5 517 534 A (KNIERIM) 14.Mai 1996**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren und Anordnungen zur Ableitung von mehreren Taktsignalen für Signalverarbeitungsschaltungen, insbesondere für einen digitalen Modem, aus einem zugeführten Taktsignal.

Zur digitalen Erzeugung und Modulation des Trägers in Modems kann die Abtastfrequenz $f_A$ in bezug auf die Symbolfrequenz $f_S$ auf zwei Arten realisiert werden. Zum einen kann ein festes, ganzzahliges Verhältnis zwischen Abtast- und Symbolfrequenz gewählt werden, so daß die Abtastung in synchroner Form erfolgt. Zusätzlich muß die Abtastfrequenz dem Abtasttheorem genügen, das heißt, sie muß größer als doppelt so groß (in der Regel viermal so groß) sein wie die Symbolfrequenz. Die synchrone Abtastung erfordert eine Taktableitung, die den Abtasttakt aus dem Symboltakt durch Frequenzteilung ableitet.

Bei der asynchronen Abtastung ist die Abtastfrequenz unabhängig von der Symbolfrequenz vorgegeben. Die asynchrone Abtastung kann an sich mit einem freilaufenden Abtasttakt arbeiten, der unabhängig vom Symboltakt ist. Bei einem Vergleich der asynchronen mit der synchronen Abtastung ist unter anderem bedeutsam, daß bei der asynchronen Abtastung trotz einer variablen Symbolrate ein erforderliches Anti-Aliasing-Filter wegen der festen Abtastfrequenz nicht variabel ausgeführt zu sein braucht. Die asynchrone Abtastung erfordert eine variable Interpolation auf der Sendeseite bzw. eine variable Dezimation auf der Empfängerseite. Ein Verfahren zur digitalen Modulation und ein digitaler Modulator mit einer asynchronen Abtastung und variabler Interpolation bzw. variabler Dezimation sind beispielsweise in DE 39 19 530 C2 und EP 0 477 131 A3 beschrieben.

Die aus DE-A- 39 19 530 bekannte Anordnung enthält einen Akkumulator vorgegebener Wortbreite. dem zwei Taktsianale und ein gespeichertes Datenwort zugeführt werden. wobei das Datenwort mit der Taktrate akkumuliert und dabei eine Modulo $2^n$-Operation ausführt wird. EP-A-0-492 588 offenbart einen digitalen Phasenregelkreis mit einem Akkumulator. der ein N-bit Register enthält und über ein Frequenzsteuerwort (digital frequency command word) voreingestellt wird.

In derartigen digitalen Modems, die außer dem eigentlichen Modulator und Demodulator noch verschiedene digitale Signalverarbeitungsschaltungen, wie beispielsweise Coder und Decoder, enthalten, werden verschiedene Taktsignale benötigt, die an die verschiedenen Bitraten der zwischen den einzelnen Schaltungen zu übertragenden Signale angepaßt sind. Dabei stehen die Taktfrequenzen nur teilweise in einem festen rationalen Verhältnis, beispielsweise 48/73. Zur Erzeugung von Taktsignalen in einem derartigen Frequenzverhältnis werden bei bekannten Modems Frequenzteiler und Phasenvergleichsschaltungen verwendet, die größtenteils in analoger Schaltungstechnik ausgeführt sind.

Aufgabe der vorliegenden Erfindung ist es, ein Verfahren und Anordnungen zur Ableitung von mehreren Taktsignalen aus einem zugeführten Taktsignal anzugeben, das ausschließlich in digitaler Schaltungstechnik durchgeführt werden kann. Dabei soll möglichst eine Flexibilität bezüglich der Symbolrate und der Datenrate sichergestellt werden.

Diese Aufgabe wird erfindungsgemäß durch die in den Ansprüchen 1 und 2 angegebenen Merkmale gelöst.

Das erfindungsgemäße Verfahren kann auch bei anderen Signalverarbeitungsschaltungen als digitalen Modems angewendet werden. Um ein digitales Modem an die jeweils geforderten Symbolraten anzupassen, kann der vorgegebene Wert jeweils programmiert werden. Zur Durchführung des Verfahrens eignet sich eine spezielle Digital-Hardware, die aufwandsgünstig in einem FPGA (Field Programmable Gate Array) oder in einem ASIC (Application Specific Intergrated Circuit) implementiert werden kann.

Insbesondere bei digitalen Modems mit asynchroner Abtastung tritt jedoch das Problem auf, daß ein zweites Taktsignal zugeführt wird, nämlich ein mit dem Symboltakt starr verkoppelter Takt, der jedoch mit dem zugeführten ersten Taktsignal nicht verkoppelt ist. Um eine dadurch entstehende Fehlerfortpflanzung in Form von Takt-Slips zu vermeiden, ist bei einer Weiterbildung des erfindungsgemäßen Verfahrens vorgesehen, daß ein zweites Taktsignal zugeführt wird und daß das Inkrement in Abhängigkeit von der Phasenlage des zweiten zugeführten Taktsignals in bezug auf eines der abzuleitenden Taktsignale verändert wird.

Diese Veränderung kann kontinuierlich oder quasi kontinuierlich erfolgen. Zur Verminderung des Rechenaufwandes kann jedoch vorgesehen sein, daß für das Inkrement jeweils mehrere vorgegebene Werte in einem Speicher abgelegt sind, von denen einer als zu akkumulierendes Inkrement in Abhängigkeit von der Phasenlage ausgewählt wird. Dabei liegt für viele Anwendungsfälle ein ausreichendes Regelverhalten vor, wenn das zu akkumulierende Inkrement aus drei vorgegebenen Werten ausgewählt wird. Dabei erfolgt eine zeitliche Anpassung der drei Punkte dieser Dreipunktregelung dadurch, daß ein gemeinsamer Teiler und eine Restfreiheit der drei Inkremente vorliegen. Welche Ausführungsform dieser Weiterbildung vom Fachmann gewählt wird, hängt wesentlich von den jeweiligen Anforderungen an die Jitter-Freiheit ab.

Diese Weiterbildung vermeidet zwar nicht einen Restjitter der abgeleiteten Taktsignale. Dieser ist jedoch bei den in Betracht gezogenen Anwendungen des erfindungsgemäßen Verfahrens im allgemeinen nicht störend. Wegen der an sich relativ konstanten Frequenzen des ersten und des zweiten zugeführten Taktsignals genügt es, wenn bei dieser Weiterbildung die drei vorgegebenen Werte sich jeweils um etwa 0,5% voneinander unterscheiden. Durch diese Weiterbildung wird außerdem ermöglicht, daß die vorgegebenen Werte von den theoretischen Werten, die sich aus den Frequenzverhältnissen ergeben, geringfügig abweichen können, so daß die Genauigkeit bzw. die Anzahl der Binärstellen in den Akkumulatoren auf praktikable Werte begrenzt werden kann.

Zur Vermeidung der obengenannten Fehlerfortpflanzung kann bei dem erfindungsgemäßen Verfahren, wenn das jeweils einem Akkumulator zugeführte Inkrement nicht restfrei ist, vorgesehen sein, daß ein weiterer Akkumulator mit einer vorgegebenen Bitbreite m und einem darstellbaren Zahlenbereich von Z ist Element von $[2^m\text{-}1,0]$ Restwerte im Takt des ersten zugeführten Taktsignals akkumuliert und daß der jeweilige Inhalt des weiteren Akkumulators nach Modulo$2^m$-Bildung einem Übertrageintrag des Akkumulators für das jeweils abzuleitende Taktsignal zugeführt wird.

Eine Fehlerfortpflanzung wird jedoch auch dann vermieden, wenn das jeweils einem Akkumulator zugeführte Inkrement restfrei in dem durch die vorgegebene Bitbreite darstellbaren Zahlenbereich durch den größten gemeinsamen Teiler aller zu realisierenden Taktumsetzverhältnisse teilbar ist.

Eine besonders einfache Ausgestaltung des erfindungsgemäßen Verfahrens besteht darin, daß die Bildung mindestens eines der abzuleitenden Taktsignale aus dem Überlauf des jeweiligen Akkumulators erfolgt. Hierbei muß jedoch ein gewisser Restjitter in Kauf genommen werden.

Eine jitterfreie Ableitung der abzuleitenden Taktsignale ist durch eine andere Ausgestaltung des erfindungsgemäßen Verfahrens dadurch möglich, daß die Bildung mindestens eines der abzuleitenden Taktsignale durch Sinusbildung des Akkumulatorinhalts, Digital/Analog-Wandlung und Nulldurchgangsdetektion erfolgt.

Die Erfindung hat besondere Bedeutung für die Ableitung von Taktsignalen in einem digitalen Modem, wobei ein zu übertragendes digitales Signal über mehrere Signalverarbeitungsschaltungen, insbesondere Coder, und über einen Zwischenspeicher einer Einrichtung zur variablen Interpolation zuführbar ist, aus welcher ein modulierter Träger mit einem ersten zugeführten Taktsignal auslesbar ist, und wobei aus dem digitalen Signal ein zweites zugeführtes Taktsignal abgeleitet wird, wobei vorgesehen ist, daß für die Signalverarbeitungsschaltungen und zum Auslesen aus dem Zwischenspeicher Taktsignale von je einem Akkumulator vorgegebener Bitbreite abgeleitet werden, der jeweils ein Inkrement im Takt des ersten zugeführten Taktsignals akkumuliert, und daß in Abhängigkeit von der Phasenlage des zweiten zugeführten Taktsignals in bezug auf eines der abgeleiteten Taktsignale die jeweils zu akkumulierenden Inkremente verändert werden.

Außer für den Sendeteil eines Modems können diese Maßnahmen auch bei dem Empfangsteil eines Modems in vorteilhafter Weise vorgesehen sein, bei dem ein empfangener modulierter Träger einer Einrichtung zur variablen Dezimation zugeführt wird, deren digitales Ausgangssignal über einen Zwischenspeicher und Signalverarbeitungsschaltungen, insbesondere Decoder, einem Ausgang zuführbar ist, bei dem ferner zum Einschreiben in die Einrichtung zur variablen Dezimation ein erstes Taktsignal zugeführt wird und bei dem aus dem digitalen Ausgangssignal der Einrichtung zur variablen Dezimation ein zweites zugeführtes Taktsignal abgeleitet wird.

Ausführungsbeispiele der Erfindung sind in der Zeichnung anhand mehrerer Figuren dargestellt und in der nachfolgenden Beschreibung näher erläutert. Es zeigt:

Fig. 1    ein Ausführungsbeispiel in Verbindung mit dem senderseitigen Teil eines Modems,

Fig. 2    ein Ausführungsbeispiel in Verbindung mit dem empfängerseitigen Teil eines Modems,

Fig. 3    ein weiteres Ausführungsbeispiel und

Fig. 4    ein Ausführungsbeispiel mit einer zusätzlichen Einrichtung zur Erzeugung eines jitterfreien Taktsignals.

Die Ausführungsbeispiele sind zwar als Blockschaltbilder dargestellt. Dieses bedeutet jedoch nicht, daß eine Anordnung zur Durchführung des erfindungsgemäßen Verfahrens auf eine Realisierung mit Hilfe von einzelnen den Blöcken entsprechenden Schaltungen beschränkt ist. Die Anordnung ist vielmehr in besonders vorteilhafter Weise mit Hilfe von hochintegrierten Schaltungen realisierbar.

Ein zu übertragendes digitales Signal ist einem Eingang 1 zuführbar, durchläuft ein digitales Signalverarbeitungssystem einschließlich eines digitalen Modulators. An einem Ausgang 2 steht dann das modulierte trägerfrequente Signal zur Verfügung. Das Signalverarbeitungssystem besteht aus einer Eingangsschaltung 3, in welcher der in den bei 1 zugeführten digitalen Signalen enthaltene Takt IR rückgewonnen wird. Daran schließt sich ein FIFO-Speicher an, dessen Funktion im einzelnen später beschrieben wird. Das zwischengespeicherte Eingangssignal wird dann bei 5 einem Framing unterworfen und durchläuft danach zwei Coder 6, 7, beispielsweise einen Reed-Solomon-Coder und einen Viterbi-Trellis-Coder.

Das Ausgangssignal des Coders 7 wird mit einem Takt SR, der der Symbolrate entspricht, in ein Filter 8 eingeschrieben. Aus dem Filter 8 wird die modulierte Trägerwelle mit einer Abtastrate SAR ausgelesen. Daran schließt sich ein Digital/Analog-Wandler 9 mit einem Anti-Aliasing-Filter 10 an. Ein Taktsignal mit der Abtastrate SAR wird einem Eingang 11 zugeführt.

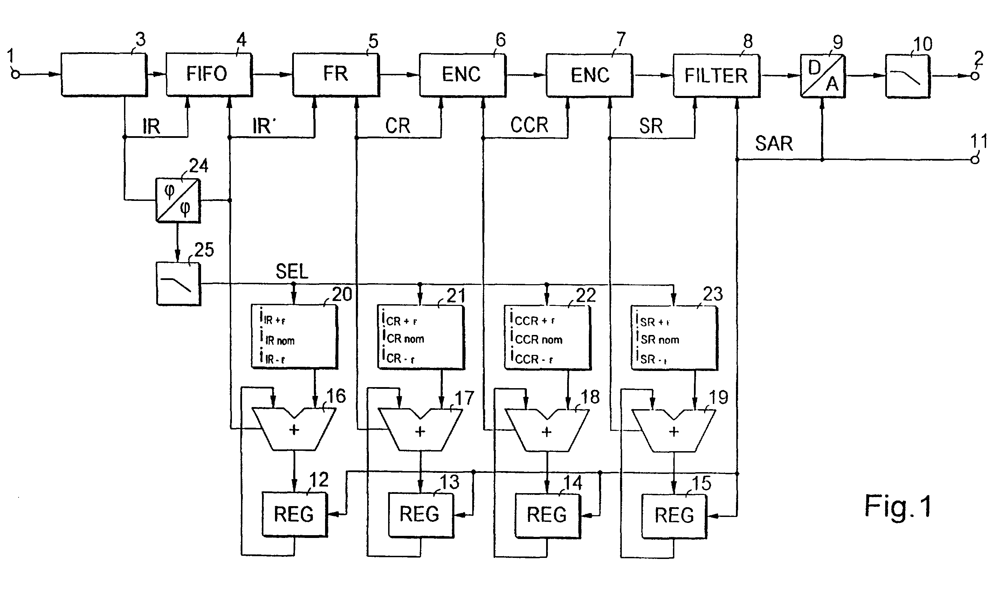

Modems dieser Art sind meistens für verschiedene Symbolraten ausgelegt, wobei entsprechend die Trägerfrequenz geändert wird. Der in Fig. 1 dargestellte senderseitige Teil eines Modems arbeitet mit einer asynchronen Abtastung, d. h. die Abtastrate SAR ist konstant, so daß auch das Anti-Aliasing-Filter 10 eine konstante Grenzfrequenz aufweist. Es ist jedoch deshalb eine Abtastratenwandlung erforderlich, was in an sich bekannter Weise im Filter 8 geschieht, welchem mit einem Eingangstakt SR die Ausgangssignale des Coders 7 zugeführt werden. Zum Auslesen aus dem Filter 8 wird der Abtasttakt SAR benutzt. Bei der Abtastratenwandlung erfolgt eine Interpolation zwischen den Abtastwerten des Ausgangssignals des Coders 7, wobei die Abtastwerte entsprechend der Phasenlage des neuen Abtastwertes zu den zu interpolierenden Abtastwerten bewertet werden.

Der ursprüngliche in den Eingangssignalen enthaltene Takt IR ist nicht mit dem Abtasttakt SAR verkoppelt. Die Framing-Schaltung 5, der Coder 6 und der Coder 7 fügen dem eingehenden Datenstrom jeweils Informationen hinzu, während die Modulation aufgrund der Symbolbildung (QPSK: 2 Bit; 8PSK: 3 Bit usw.) zu einer Verringerung der Taktrate führt. Daher weist der jeweils eine dieser Schaltungen verlassende Datenstrom eine andere Abtastrate auf als der Datenstrom am Eingang. Die Framing-Schaltung 5 erhält als Eingangstakt einen Takt IR', der gemittelt die Frequenz des Eingangstaktes IR aufweist, jedoch kurzfristig gegenüber diesem schwanken kann, wozu die Signale in einen FIFO-Speicher 4 zwischengespeichert werden.

Die Framing-Schaltung 5 erhält einen Takt CR (= Composite Rate), der auch dem Coder 6 als Eingangstakt dient. Dieser wiederum erhält als Ausgangstakt den Takt CCR (= Coded Composite Rate), mit welchem die bei 6 codierten Signale dann dem Coder 7 zugeführt werden.

Zur Erzeugung der genannten Taktsignale sind bei der Anordnung nach Fig. 1 vier numerisch gesteuerte Oszillatoren (NCO) vorgesehen, die mit dem bei 11 zugeführten Abtasttakt SAR getaktet werden. Jeder dieser numerisch gesteuerten Oszillatoren enthält einen aus einem Register 12, 13, 14, 15 und einem Addierer 16, 17, 18, 19 gebildeten Akkumulator, der mit jedem gemeinsamen zugeführten Takt einen vorgegebenen Wert aus einem Speicher 20, 21, 22, 23 dem vorangegangenen Wert hinzuaddiert. Durch die Kapazität des Akkumulators und den jeweils hinzuzuaddierenden Wert ergibt sich eine Frequenzteilung des Taktes SAR, deren Größe durch den jeweils in den Speichern 20 bis 23 abgelegten Wert festlegbar ist.

Eine Taktumsetzung entsprechend einer PLL-Funktion, welche jeweils einen Ausgangs- und einen Eingangstakt miteinander verknüpft, basiert im wesentlichen auf zwei Teilern L und M, die das Verhältnis der Taktumsetzung festlegen. In den folgenden Ausführungen wird eine Baugruppe, die jeweils aus dem Filter 8, 34 und einer zugehörigen Takterzeugung besteht, COVADI (Complex Variable Decimator/Interpolator) genannt.

Eine Ausgangsfrequenz $f_o$ ergibt sich aus einer Eingangsfrequenz $f_i$ zu:

$$f_o = L/M * f_i;$$

L < M sei stets angenommen (L, M ganzzahlig)

Im Falle z.B. einer Reed-Solomon-Codierung 6 können sich die Teilerfaktoren im Bereich:

$$1 < L, M < 256$$

bewegen.

Kommt z.B. eine Faltungscodierung 7 im Bereich der Rate 1/2 bis 7/8 hinzu, so erweitert sich der Bereich von L und M um einen Faktor bis zu acht.

Bei Einsatz eines numerisch gesteuerten Oszillators für die Taktung des Filters 8 kann der umgesetzte Takt am einfachsten durch eine parallel getaktete und damit phasenstarr verkoppelte zweite NCO-Funktion mit einem, dem Umsetzverhältnis entsprechenden Inkrement $i_2$ realisiert werden.

Der Gleichlauf der Phasen-Akkumulatoren ist in einem synchronen, digitalen System einfach dadurch zu realisieren, daß beide Akkumulatoren zeitgleich behandelt werden. Eine eventuelle Fehlerfortpflanzung bei der Akkumulation kann mit den eingangs genannten Weiterbildungen gelöst werden, wobei in den Ausführungsbeispielen nach den Figuren 1, 2 und 4 ein variables Phaseninkrement im Sinne einer Dreipunktregelung verwendet wird.

Diese Dreipunktregelung geht von drei unterschiedlichen Werten für ein zu realisierendes Phaseninkrement aus:

1. Einem nominalen Wert $i_{nom}$ für das Phaseninkrement,
2. einem Wert $i_{+\varepsilon}$, der geringfügig (ca. 0,5%) größer als der Nominalwert $i_{nom}$ ist,
3. einem Wert $i_{-\varepsilon}$, der geringfügig (ca. 0,5%) kleiner als der Nominalwert $i_{nom}$ ist.

Die Regelung sorgt dafür, daß zwischen diesen drei Werten des Phaseninkrementes so hin- und hergeschaltet wird, daß sich im Mittel der erforderliche Wert für das Inkrement ergibt. Liegt der erforderliche Wert für das Inkrement beispielsweise über dem Nominalwert, so sorgt die Regelung dafür, daß im Mittel öfter der größere Wert $i_{+\varepsilon}$ verwendet wird als der kleinere Wert $i_{-\varepsilon}$.

Ein Freiheitsgrad ist die Festlegung dieser drei Werte $i_{nom}$, $i_{+\varepsilon}$ und $i_{-\varepsilon}$ derart, daß Quantisierungsfehler R bei allen erforderlichen Taktumsetzungen sämtlich zu Null gemacht werden. Aufgrund der in gewissen Bereichen nahezu freien Wahl der drei Werte $i_{nom}$, $i_{+\varepsilon}$ und $i_{-\varepsilon}$ ist es jedoch möglich zu erreichen, daß folgendes gilt:

$$R_{nom} = R_{+\varepsilon} = R_{-\varepsilon} = 0.$$

Bei der Anordnung nach Fig. 1 sind für jeden der Takte IR', CR, CCR und SR drei Werte des Phaseninkrements i in dem jeweiligen Speicher 20 bis 23 abgelegt. Eine Phasenvergleichsschaltung 24 mit einem anschließenden Tiefpaßfilter 25 leitet ein Signal SEL ab, das bewirkt, daß jeweils einer der Werte der Phaseninkremente dem jeweiligen Addierer zugeführt wird.

Im folgenden werden für verschiedene Beispiele die zur Erzielung der jeweiligen Taktfrequenzen erforderlichen Phaseninkremente berechnet.

Beispiel 1: (b = 24bit)

Annahmen:

| Abtastrate SAR | SAR=12,5 MHz (Eingang COVADI!) |
|---|---|
| Inforate IR | IR=2,048 MHz (Standard-E1!) |
| Compositerate CR | CR=2,144 MHz (Overheadrate: OR=96 kHz) |
| Coded Compositerate | CCR=2,336 MHz (RS-Coderate: 201/219) |
| Symbolrate SR | SR=1,55733.. MHz (FEC-Rate: 3/4;QPSK-Mod.) |
| Doppelte Symbolrate | DSR=3,11466.. MHz (Ausgang COVADI!) |

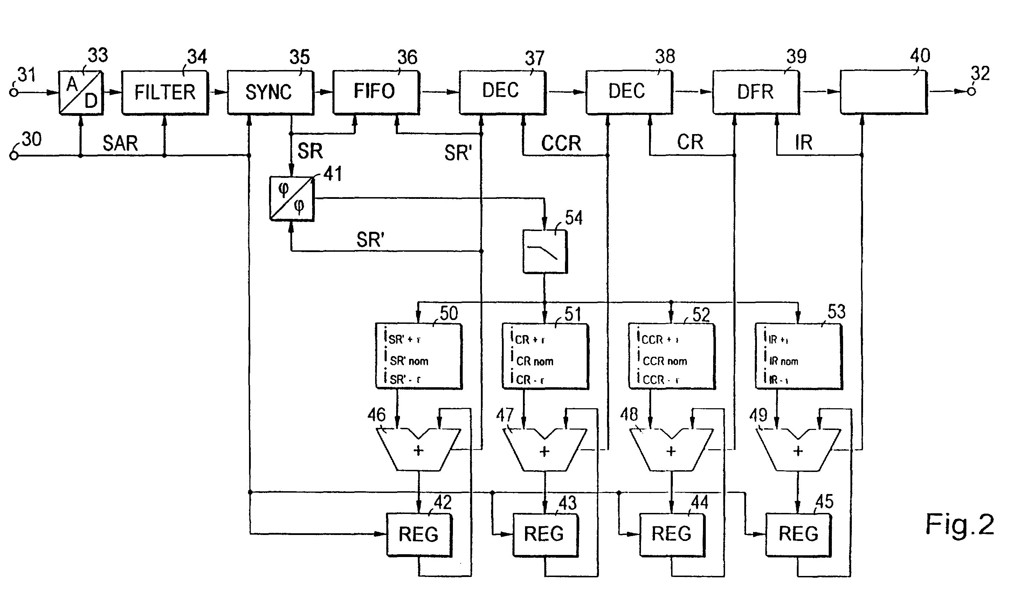

Betrachtet werden soll die Empfangsseite in Fig. 2. Bei den obigen Annahmen ergibt sich ein nominaler Dezimationsfaktor $d_{nom}$ von:

$$d_{nom} = SAR/DSR = 4{,}013270548$$

Hieraus ergibt sich ein Nominalwert $i_{nom}$ für das Phaseninkrement zur Erzeugung der doppelten Symbolrate DSR von (Annahme: b = 24 bit):

$$i_{nom} = 2^b * (d_{nom})^{-1} = 0{,}249173333 * 2^{24} = 4\ 180\ 434{,}835$$

Bei einer angenommenen Abweichung E von $\pm$0,5% ergeben sich die Inkremente $i_{+\varepsilon}$ und $i_{-\varepsilon}$ zu:

$$i_{+\varepsilon} = i_{nom}(1+\varepsilon) = 0{,}250419200 * 2^{24} = 4\ 201\ 337{,}009$$

und:

$$i_{-\varepsilon} = i_{nom}(1-\varepsilon) = 0{,}247927466 * 2^{24} = 4\ 159\ 532{,}661$$

Nach einer Quantisierung auf ganze Zahlen ergibt sich schließlich:

inom = 4 180 435
$i_{+\varepsilon}$ = 4 201 337
$i_{-\varepsilon}$ = 4 159 533

Diese drei Werte ergeben sich zunächst ohne Berücksichtigung einer zu realisierenden Taktumsetzung mit Hilfe des aufwandsoptimierten Konzeptes der virtuellen PLL.

Bei einem verkettet codierten System, wie in diesem Beispiel angenommen, ergeben sich die Teilerfaktoren einer PLL multiplikativ aus den einzelnen Umsetzfaktoren. Konkret heisst dies im vorliegenden Beispiel:

Ausgangspunkt ist die doppelte Symbolrate DSR am Ausgang des COVADI-Bausteins. Eine erste Umsetzung erfolgt innerhalb des SYNC-Bausteines auf die Symbolrate SR durch einfaches Ausblenden jedes zweiten Strobe-Impulses von DSR im SYNC.

Teilerfaktoren SYNC:

$$L_{SYNC} = 1 \; ; \; M_{SYNC} = 2$$

Die nächste Umsetzung ergibt sich am Viterbi-Decoder 7, an dem eine FEC-Rate 3/4 vorliegt und außerdem zu berücksichtigen ist, daß QPSK-Modulation vorliegt und somit 2 bit pro Symbol übertragen werden.

$$(L_{FEC}/M_{FEC} = 3/4 * 2/1 = 3/2)$$

Teilerfaktoren FEC:

$$L_{FEC} = 3 \; ; \; M_{FEC} = 2$$

In der Decodier-Kette folgt die Reed-Solomon Decodierung mit einer RS-Coderate von 201/219.

Teilerfaktoren RS:

$$L_{RS} = 201 \; ; \; M_{RS} = 219$$

Als letzter Schritt erfolgt schließlich das Deframing auf der Empfangsseite mit einer ESC-Umsetzrate, die sich für eine Inforate IR von 2,048 MHz zu 2048/(2048 + 96) ergibt.

Teilerfaktoren ESC:

$$L_{ESC} = 2 \, 048 \; ; \; M_{ESC} = 2 \, 144$$

Damit ergibt sich für das Umsetzverhältnis von der doppelten Symbolrate DSR zu der Inforate IR am Ausgang der Deframing-Einheit:

$$IR/DSR = (L_{SYNC}/M_{SYNC})*(L_{FEC}/M_{FEC})*(L_{RS}/M_{RS})*(L_{ESC}/M_{ESC})$$

$$IR/DSR = (1/2) * (3/2) * (201/219) * (2048/2144)$$

Nach weitest möglicher Kürzung gemeinsamer Teiler ergibt sich schließlich:

$$IR/DSR = 48/73 \qquad d.h. \; L_{IR} = 48 \; ; \; M_{IR} = 73$$

In diesem speziellen Fall ergeben sich vergleichsweise kleine Teilerfaktoren.

Für das Umsetzverhältnis von DSR zu der Compositerate CR ergibt sich:

$$CR/DSR = (L_{SYNC}/M_{SYNC}) * (L_{FEC}/M_{FEC}) * (L_{RS}/M_{RS})$$

Nach weitest möglicher Kürzung gemeinsamer Teiler ergibt sich hier:

$$CR/DSR = 201/292 \text{ d.h.} \qquad L_{CR} = 201 ; M_{CR} = 292$$

Schließlich ergibt sich für das Umsetzverhältnis von DSR zu der Coded Compositerate CCR:

$$CCR/DSR = (L_{SYNC}/M_{SYNC}) * (L_{FEC}/M_{FEC})$$

$$CCR/DSR = 3/4 \qquad \text{d.h. } L_{CCR} = 3 ; M_{CCR} = 4$$

Das kleinste, gemeinsame Vielfache der Nenner M bei sämtlichen, umzusetzenden Taktraten liegt mit $M_{CR}$ = 292 bei der Compositerate CR vor. Die beiden anderen Umsetzverhältnisse können entsprechend erweitert werden, so daß der Nenner jeweils identisch zu $M_{CR}$ = 292 ist. Damit ergibt sich:

$$IR/DSR = 48/73 = 192/292$$

$$CR/DSR = 201/292$$

$$CCR/DSR = 3/4 = 219/292$$

Werden die drei Phaseninkremente $i_{nom}$, $i_{+\varepsilon}$ und $i_{-\varepsilon}$ so optimiert, d.h. modifiziert, daß alle drei durch den Nenner $M_{CR}$ = 292 teilbar sind, ergeben sich einerseits die optimierten Phaseninkremente $i_{nom,opt}$, $i_{+\varepsilon,opt}$ und $i_{-\varepsilon,opt}$, andererseits ist damit auch die Bedingung $R_{nom} = R_{+\varepsilon} = R_{-\varepsilon} = 0$ erfüllt.
Konkret heißt das im vorliegenden Beispiel:

$$i_{nom} = 4\,180\,435 \gg i_{nom,opt} = 4\,180\,564$$

$$i_{+\varepsilon} = 4\,201\,337 \gg i_{+\varepsilon,opt} = 4\,201\,296$$

$$i_{-\varepsilon} = 4\,159\,533 \gg i_{-\varepsilon,opt} = 4\,159\,540$$

Anstelle der ursprünglich vorgegebenen Abweichung $\varepsilon$ von $\pm 0{,}5\%$ ergeben sich aus den optimierten Inkrementen $i_{nom,opt}$, $i_{+\varepsilon,opt}$ und $i_{-\varepsilon,opt}$ folgende Abweichungen:

$$\varepsilon_+ = +0{,}5\% \gg \varepsilon_{+,opt} = +0{,}496\%$$

$$\varepsilon_- = -0{,}5\% \gg \varepsilon_{-,opt} = -0{,}503\%$$

Hierbei hat sich auch der Nominalwert $i_{nom,opt}$ gegenüber $i_{nom}$ um eine Abweichung $\delta$ von $\delta$ = +0,003% verschoben.
Der Vollständigkeit halber sollen im folgenden jeweils die drei Phaseninkremente für die einzelnen Taktumsetzungen angegeben werden:

| CCR | CCR/DSR | = 219/292 |
|-----|---------|-----------|
|     | $i_{CCR,nom,opt}$ | = 3 135 423 |
|     | $i_{CCR,+\varepsilon,opt}$ | = 3 150 972 |
|     | $i_{CCR,\varepsilon,opt}$ | = 3 119 655 |
| CR  | CR/DSR | = 201/292 |

(fortgesetzt)

| | | |
|---|---|---|
| | $i_{CR,nom,opt}$ | = 2 877 717 |
| | $i_{CR,+\varepsilon,opt}$ | = 2 891 988 |
| IR | $i_{CR,-\varepsilon,opt}$ | = 2 863 245 |
| | IR/DSR | = 192/292 |
| | $i_{IR,nom,opt}$ | = 2 748 864 |
| | $i_{IR,+\varepsilon,opt}$ | = 2 762 496 |
| | $i_{IR,-\varepsilon,opt}$ | = 2 735 040 |

Bei größeren Werten für den größten, auftretenden Nenner M und bei kleinen Werten für die drei Phaseninkremente $i_{nom}$, $i_{+\varepsilon}$ und $i_{-\varepsilon}$ (d.h. bei kleineren Datenraten) ergibt sich eine zunehmende Diskrepanz zwischen den vorgegebenen und tatsächlichen Abweichungen (Genauigkeitsproblem!).

Dies stellt jedoch kein grundsätzliches Problem dar, da mit Hilfe einer Vergrößerung der Wortbreite b (obiges Beispiel war für b = 24 bit) eine direkte Beeinflussung der Ungenauigkeiten gegeben ist. Eine Erhöhung der Wortbreite b auf z.B. b = 32 bit ist für den COVADI-Baustein ohne größeren Aufwand bei einem Redesign möglich.

Ein weiteres Beispiel soll dazu dienen, die erforderliche Wortbreite b abzuschätzen.

Beispiel 2: (b = 32 bit)

Annahmen:

| | |
|---|---|
| Abtastrate SAR | SAR = 12,5 MHz (Eingang COVADI!) |
| Inforate IR | IR = 8,448 MHz (Standard-E2!) |
| Compositerate CR | CR=8,544 MHz (Overheadrate: OR=96 kHz) |
| Coded Compositerate | CCR=9,27115..MHz (RS-Coderate: 235/255) |
| Symbolrate SR | SR=4,63557.. MHz (FEC-Rate: 2/3; 8-PSK-Mod.) |
| Doppelte Symbolrate | DSR=9,27115.. MHz (Ausgang COVADI!) |

Bei den obigen Annahmen ergibt sich ein nominaler Dezimationsfaktor $d_{nom}$ von:

$$d_{nom} = SAR/DSR = 1{,}348268708$$

Hieraus ergibt sich ein Nominalwert $i_{nom}$ für das Phaseninkrement zur Erzeugung der doppelten Symbolrate DSR von (Annahme: b = 32 bit):

$$i_{nom} = 2^b * (d_{nom})^{-1} = 0{,}741691915 * 2^{32} = 3\,185\,542\,519,..$$

Bei einer angenommenen Abweichung $\varepsilon$ von $\pm 0{,}5\%$ ergeben sich die Inkremente $i_{+\varepsilon}$ und $i_{-\varepsilon}$ zu:

$$i_{+\varepsilon} = i_{nom}(1+\varepsilon) = 0{,}745400374 * 2^{32} = 3\,201\,470\,231,..$$

und:

$$i_{-\varepsilon} = i_{nom}(1-\varepsilon) = 0{,}737983455 * 2^{32} = 3\,169\,614\,806,..$$

Nach einer Quantisierung auf ganze Zahlen ergibt sich schließlich:

$i_{nom}$ = 3 185 542 519
$i_{+\varepsilon}$ = 3 201 470 231
$i_{-\varepsilon}$ = 3 169 614 806

Diese drei Werte ergeben sich zunächst ohne Berücksichtigung einer zu realisierenden Taktumsetzung mit Hilfe des aufwandsoptimierten Konzeptes der virtuellen PLL.

Bei einem verkettet codierten System, wie in diesem Beispiel angenommen, ergeben sich die Teilerfaktoren einer PLL multiplikativ aus den einzelnen Umsetzfaktoren. Konkret heißt dies im vorliegenden Beispiel:

Ausgangspunkt ist die doppelte Symbolrate DSR am Ausgang des COVADI-Bausteins. Eine erste Umsetzung erfolgt innerhalb des SYNC-Bausteines auf die Symbolrate SR durch einfaches Ausblenden jedes zweiten Strobe-Impulses von DSR im SYNC.

Teilerfaktoren SYNC:

$$L_{SYNC} = 1 \; ; M_{SYNC} = 2$$

Die nächste Umsetzung ergibt sich am Trellis-Decoder, an dem eine FEC-Rate 2/3 vorliegt und außerdem zu berücksichtigen ist, daß 8-PSK-Modulation vorliegt und somit 3 bit pro Symbol übertragen werden.

$$(L_{FEC}/M_{FEC} = 2/3 * 3/1 = 2/1)$$

Teilerfaktoren FEC:

$$L_{FEC} = 2 \; ; M_{FEC} = 1$$

In der Decodier-Kette folgt die Reed-Solomon Decodierung mit einer RS-Coderate von 235/255.

Teilerfaktoren RS:

$$L_{RS} = 235 \; ; M_{RS} = 255$$

Als letzter Schritt erfolgt schließlich das Deframing auf der Empfangsseite mit einer ESC-Umsetzrate, die sich für eine Inforate IR von 8,448 MHz zu 8448/(8448 + 96) ergibt.

Teilerfaktoren ESC:

$$L_{ESC} = 8\,448 \; ; M_{ESC} = 8\,544$$

Damit ergibt sich für das Umsetzverhältnis von der doppelten Symbolrate DSR zu der Inforate IR am Ausgang der Deframing-Einheit:

$$IR/DSR = (L_{SYNC}/M_{SYNC})*(L_{FEC}/M_{FEC})*(L_{RS}/M_{RS})*(L_{ESC}/M_{ESC})$$

$$IR/DSR = (1/2) * (2/1) * (235/255) * (8\,448/8\,544)$$

Nach weitest möglicher Kürzung gemeinsamer Teiler ergibt sich schließlich:

$$IR/DSR = 4\,136/4\,539 \qquad \text{d.h. } L_{IR} = 4\,136 \; ; M_{IR} = 4\,539$$

In diesem speziellen Fall ergeben sich vergleichsweise kleine Teilerfaktoren.

Für das Umsetzverhältnis von DSR zu der Compositerate CR ergibt sich:

$$CR/DSR = (L_{SYNC}/M_{SYNC}) * (L_{FEC}/M_{FEC}) * (L_{RS}/M_{RS})$$

Nach weitest möglicher Kürzung gemeinsamer Teiler ergibt sich hier:

$$CR/DSR = 47/51 \qquad d.h.\ L_{CR} = 47\ ;\ M_{CR} = 51$$

Schließlich ergibt sich für das Umsetzverhältnis von DSR zu der Coded Compositerate CCR:

$$CCR/DSR = (L_{SYNC}/M_{SYNC}) * (L_{FEC}/M_{FEC})$$

$$CCR/DSR = 1/1 \qquad d.h.\ L_{CCR} = 1\ ;\ M_{CCR} = 1$$

Das kleinste, gemeinsame Vielfache der Nenner M bei sämtlichen, umzusetzenden Taktraten liegt mit $M_{IR}$ = 4539 bei der Inforate IR vor. Die beiden anderen Umsetzverhältnisse können entsprechend erweitert werden, so daß der Nenner jeweils identisch zu $M_{IR}$ = 4 539 ist.
Damit ergibt sich:

$$IR/DSR = 4\ 136/4\ 539$$

$$CR/DSR = 47/51 = 4\ 183/4\ 539$$

$$CCR/DSR = 1/1 = 4\ 539/4\ 539$$

Werden die drei Phaseninkremente $i_{nom}$, $i_{+\varepsilon}$ und $i_{-\varepsilon}$ so optimiert, d.h. modifiziert, daß alle drei durch den Nenner $M_{IR}$ = 4 539 teilbar sind, ergeben sich einerseits die optimierten Phaseninkremente $i_{nom,opt}$, $i_{+\varepsilon,opt}$ und $i_{-\varepsilon,opt}$, andererseits ist damit auch die Bedingung $R_{nom} = R_{+\varepsilon} = R_{-\varepsilon} = 0$ erfüllt.
Konkret heißt das im vorliegenden Beispiel:

$$i_{nom} = 3\ 185\ 542\ 519 >> i_{nom,opt} = 3\ 185\ 542\ 824$$

$$i_{+\varepsilon} = 3\ 201\ 470\ 231 >> i_{+\varepsilon,opt} = 3\ 201\ 470\ 175$$

$$i_{-\varepsilon} = 3\ 169\ 614\ 806 >> i_{-\varepsilon,opt} = 3\ 169\ 615\ 473$$

Anstelle der ursprünglich vorgegebenen Abweichung E von $\pm0,5\%$ ergeben sich aus den optimierten Inkrementen $i_{nom,opt}$, $i_{+\varepsilon,opt}$ und $i_{-\varepsilon,opt}$ folgende Abweichungen:

$$\varepsilon_{+} = +0,5\% >> \varepsilon_{+,opt} = +0,499989\%$$

$$\varepsilon_{-} = -0,5\% >> \varepsilon_{-,opt} = -0,499989\%$$

Hierbei hat sich auch der Nominalwert $i_{nom,opt}$ gegenüber $i_{nom}$ um eine Abweichung $\delta$ von $\delta$ = +0,00001% verschoben.
Der Vollständigkeit halber sollen im folgenden jeweils die drei Phaseninkremente für die einzelnen Taktumsetzungen angegeben werden:

| CCR | CCR/DSR | = 5 139/5 139 |
|---|---|---|
| | $i_{CCR,nom,opt}$ | = 3 185 542 824 |
| | $i_{CCR,+\varepsilon,opt}$ | = 3 201 470 175 |
| | $i_{CCR,-\varepsilon,opt}$ | = 3 169 615 473 |
| CR | CR/DSR | = 4 183/4 539 |
| | $i_{CR,nom,opt}$ | = 2 935 696 328 |
| | $i_{CR,+\varepsilon,opt}$ | = 2 950 374 475 |
| | $i_{CR,-\varepsilon,opt}$ | = 2 921 018 181 |
| IR | IR/DSR | = 4 136/4 539 |
| | $i_{IR,nom,opt}$ | = 2 902 710 976 |
| | $i_{IR,+\varepsilon,opt}$ | = 2 917 224 200 |
| | $i_{IR,-\varepsilon,opt}$ | = 2 888 197 752 |

Beispiel 3: (b = 24 bit; sonst wie Beispiel 2)

Annahmen:

| Abtastrate SAR | SAR = 12,5 MHz (Eingang COVADI!) |
|---|---|
| Inforate IR | IR = 8,448 MHz (Standard-E2!) |
| Compositerate CR | CR = 8,544 MHz (Overheadrate: OR = 96kHz) |
| Coded Compositerate | CCR=9,27115..MHz (RS-Coderate: 235/255) |
| Symbolrate SR | SR=4,63557.. MHz (FEC-Rate: 2/3;8-PSK-Mod.) |
| Doppelte Symbolrate | DSR = 9,27115..MHz (Ausgang COVADI!) |

Bei den obigen Annahmen ergibt sich ein nominaler Dezimationsfaktor $d_{nom}$ von:

$$d_{nom} = SAR/DSR = 1{,}348268708$$

Hieraus ergibt sich ein Nominalwert $i_{nom}$ für das Phaseninkrement zur Erzeugung der doppelten Symbolrate DSR von (Annahme: b = 24 bit):

$$i_{nom} = 2^b * (d_{nom})^{-1} = 0{,}741691915 * 2^{24} = 12\ 443\ 525{,}46$$

Bei einer angenommenen Abweichung E von $\pm0,5\%$ ergeben sich die Inkremente $i_{+\varepsilon}$ und $i_{-\varepsilon}$ zu:

$$i_{+\varepsilon} = i_{nom}(1+\varepsilon) = 0{,}745400374 * 2^{24} = 12\ 505\ 743{,}08$$

und:

$$i_{-\varepsilon} = i_{nom}(1-\varepsilon) = 0{,}737983455 * 2^{24} = 12\ 381\ 307{,}83$$

Nach einer Quantisierung auf ganze Zahlen ergibt sich schließlich:

$i_{nom}$ = 12 443 525
$i_{+\varepsilon}$ = 12 505 743
$i_{-\varepsilon}$ = 12 381 308

Diese drei Werte ergeben sich zunächst ohne Berücksichtigung einer zu realisierenden Taktumsetzung mit Hilfe des aufwandsoptimierten Konzeptes der virtuellen PLL.

Bei einem verkettet codierten System, wie in diesem Beispiel angenommen, ergeben sich die Teilerfaktoren einer PLL multiplikativ aus den einzelnen Umsetzfaktoren. Konkret heißt dies im vorliegenden Beispiel:

Ausgangspunkt ist die doppelte Symbolrate DSR am Ausgang des COVADI-Bausteins. Eine erste Umsetzung erfolgt innerhalb des SYNC-Bausteines auf die Symbolrate SR durch einfaches Ausblenden jedes zweiten Strobe-Impulses von DSR im SYNC.

Teilerfaktoren SYNC:

$$L_{SYNC} = 1 \; ; \; M_{SYNC} = 2$$

Die nächste Umsetzung ergibt sich am Trellis-Decoder, an dem eine FEC-Rate 2/3 vorliegt und außerdem zu berücksichtigen ist, daß 8-PSK-Modulation vorliegt und somit 3 bit pro Symbol übertragen werden.

$$(L_{FEC}/M_{FEC} = 2/3 * 3/1 = 2/1)$$

Teilerfaktoren FEC:

$$L_{FEC} = \; ; \; M_{FEC} = 1$$

In der Decodier-Kette folgt die Reed-Solomon Decodierung mit einer RS-Coderate von 235/255.

Teilerfaktoren RS:

$$L_{RS} = 235 \; ; \; M_{RS} = 255$$

Als letzter Schritt erfolgt schließlich das Deframing auf der Empfangsseite mit einer ESC-Umsetzrate, die sich für eine Inforate IR von 8,448 MHz zu 8448/(8448 + 96) ergibt.

Teilerfaktoren ESC:

$$L_{ESC} = 8\,448 \; ; \; M_{ESC} = 8\,544$$

Damit ergibt sich für das Umsetzverhältnis von der doppelten Symbolrate DSR zu der Inforate IR am Ausgang der Deframing-Einheit:

$$IR/DSR = (L_{SYNC}/M_{SYNC})*(L_{FEC}/M_{FEC})*(L_{RS}/M_{RS})*(L_{ESC}/M_{ESC})$$

$$IR/DSR = (1/2) * (2/1) * (235/255) * (8\,448/8\,544)$$

Nach weitest möglicher Kürzung gemeinsamer Teiler ergibt sich schließlich:

$$IR/DSR = 4\,136/4\,539 \qquad \text{d.h. } L_{IR} = 4\,136 \; ; \; M_{IR} = 4\,539$$

In diesem speziellen Fall ergeben sich vergleichsweise kleine Teilerfaktoren.

Für das Umsetzverhältnis von DSR zu der Compositerate CR ergibt sich:

$$CR/DSR = (L_{SYNC}/M_{SYNC}) * (L_{FEC}/M_{FEC}) * (L_{RS}/M_{RS})$$

Nach weitest möglicher Kürzung gemeinsamer Teiler ergibt sich hier:

$$CR/DSR = 47/51 \qquad \text{d.h. } L_{CR} = 47 \; ; \; M_{CR} = 51$$

Schließlich ergibt sich für das Umsetzverhältnis von DSR zu der Coded Compositerate CCR:

$$CCR/DSR = (L_{SYNC}/M_{SYNC}) * (L_{FEC}/M_{FEC})$$

$$CCR/DSR = 1/1 \qquad \text{d.h. } L_{CCR} = 1 \text{ ; } M_{CCR} = 1$$

Das kleinste, gemeinsame Vielfache der Nenner M bei sämtlichen, umzusetzenden Taktraten liegt mit $M_{IR} = 4539$ bei der Inforate IR vor. Die beiden anderen Umsetzverhältnisse können entsprechend erweitert werden, so daß der Nenner jeweils identisch zu $M_{IR} = 4\,539$ ist.

Damit ergibt sich:

$$IR/DSR = 4\,136/4\,539$$

$$CR/DSR = 47/51 = 4\,183/4\,539$$

$$CCR/DSR = 1/1 = 4\,539/4\,539$$

Werden die drei Phaseninkremente $i_{nom}$, $i_{+\varepsilon}$ und $i_{-\varepsilon}$ so optimiert, d.h. modifiziert, daß alle drei durch den Nenner $M_{IR} = 4\,539$ teilbar sind, ergeben sich einerseits die optimierten Phaseninkremente $i_{nom,opt}$, $i_{+\varepsilon,opt}$ und $i_{-\varepsilon,opt}$, andererseits ist damit auch die Bedingung $R_{nom} = R_{+\varepsilon} = R_{-\varepsilon} = 0$ erfüllt. Konkret heißt das im vorliegenden Beispiel:

$$i_{nom} = 12\,443\,525 \gg i_{nom,opt} = 12\,441\,399$$

$$i_{+\varepsilon} = 12\,505\,743 \gg i_{+\varepsilon,opt} = 12\,504\,945$$

$$i_{-\varepsilon} = 12\,381\,308 \gg i_{-\varepsilon,opt} = 12\,382\,392$$

Anstelle der ursprünglich vorgegebenen Abweichung E von $\pm 0{,}5\%$ ergeben sich aus den optimierten Inkrementen $i_{nom,opt}$, $i_{+\varepsilon,opt}$ und $i_{-\varepsilon,opt}$ folgende Abweichungen:

$$\varepsilon_+ = +0{,}5\% \gg \varepsilon_{+,opt} = +0{,}511\%$$

$$\varepsilon_- = -0{,}5\% \gg \varepsilon_{-,opt} = -0{,}474\%$$

Hierbei hat sich auch der Nominalwert $i_{nom,opt}$ gegenüber $i_{nom}$ um eine Abweichung $\delta$ von $\delta = -0{,}017\%$ verschoben.

Der Vollständigkeit halber sollen im folgenden jeweils die drei Phaseninkremente für die einzelnen Taktumsetzungen angegeben werden:

| CCR | CCR/DSR | = 4 539/4 539 |
|-----|---------|---------------|
|  | $i_{CCR,nom,opt}$ | = 12 441 399 |
|  | $i_{CCR,+\varepsilon,opt}$ | = 12 504 945 |
|  | $i_{CCR,-\varepsilon,opt}$ | = 12 382 392 |
| CR | CR/DSR | = 4 183/4 539 |
|  | $i_{CR,nom,opt}$ | = 11 465 603 |
|  | $i_{CR,+\varepsilon,opt}$ | = 11 524 165 |

(fortgesetzt)

| IR | $i_{CR,-\varepsilon,opt}$ | = 11 411 224 |
| | IR/DSR | = 4 136/4 539 |
| | $i_{IR,nom,opt}$ | = 11 336 776 |
| | $i_{IR,+\varepsilon,opt}$ | = 11 394 680 |
| | $i_{IR,-\varepsilon,opt}$ | = 11 283 008 |

Ein weiteres Beispiel soll den Einfluß einer kleinen Datenrate auf die Parameter der virtuellen PLL zeigen. Auch mit diesem Beispiel soll die Wortbreite b etwas genauer definiert werden.

Beispiel 4: (b = 24 bit)

Annahmen:

| Abtastrate SAR | SAR = 2,5 MHz (Eingang COVADI!) |
| Inforate IR | IR = 64 kHz (Kleinste Inforate USM9000!) |
| Compositerate CR | CR=68,266..kHz (Overhead IBS: OR=1/15*IR) |
| Coded Compositerate | CCR=76,8 kHz (RS-Coderate: 112/126) |
| Symbolrate SR | SR=51,2 kHz (FEC-Rate: 3/4; QPSK-Mod.) |
| Doppelte Symbolrate | DSR = 102,4 kHz (Ausgang COVADI!) |

Bei den obigen Annahmen ergibt sich ein nominaler Dezimationsfaktor $d_{nom}$ von:

$$d_{nom} = SAR/DSR = 122,0703125$$

Hieraus ergibt sich ein Nominalwert $i_{nom}$ für das Phaseninkrement zur Erzeugung der doppelten Symbolrate DSR von (Annahme: b = 24 bit):

$$i_{nom} = 2^b * <d_{nom})^{-1} = 0,008192 * 2^{24} = 137\ 438,9535$$

Bei einer angenommenen Abweichung $\varepsilon$ von $\pm 0,5\%$ ergeben sich die Inkremente $i_{+\varepsilon}$ und $i_{-\varepsilon}$ zu:

$$i_{+\varepsilon} = i_{nom} (1 + \varepsilon) = 0,00823296 * 2^{24} = 138\ 126,1482$$

und:

$$i_{-\varepsilon} = i_{nom}(1 - \varepsilon) = 0,00815104 * 2^{24} = 136\ 751,7587$$

Nach einer Quantisierung auf ganze Zahlen ergibt sich schließlich:

$i_{nom} = 137\ 439$
$i_{+\varepsilon} = 138\ 126$
$i_{-\varepsilon} = 136\ 752$

Diese drei Werte ergeben sich zunächst ohne Berücksichtigung einer zu realisierenden Taktumsetzung mit Hilfe des aufwandsoptimierten Konzeptes der virtuellen PLL.

Bei einem verkettet codierten System, wie in diesem Beispiel angenommen, ergeben sich die Teilerfaktoren einer PLL multiplikativ aus den einzelnen Umsetzfaktoren. Konkret heißt dies im vorliegenden Beispiel:

Ausgangspunkt ist die doppelte Symbolrate DSR am Ausgang des COVADI-Bausteins. Eine erste Umsetzung erfolgt innerhalb des SYNC-Bausteines auf die Symbolrate SR durch einfaches Ausblenden jedes zweiten Strobe-Impulses von DSR im SYNC.

Teilerfaktoren SYNC:

$$L_{SYNC} = 1 \; ; M_{SYNC} = 2$$

Die nächste Umsetzung ergibt sich am Viterbi-Decoder, an dem eine FEC-Rate 3/4 vorliegt und außerdem zu berücksichtigen ist, daß QPSK-Modulation vorliegt und somit 2 bit pro Symbol übertragen werden.

$$(L_{FEC}/M_{FEC} = 3/4 * 2/1 = 3/2)$$

Teilerfaktoren FEC:

$$L_{FEC} = 3 \; ; M_{FEC} = 2$$

In der Decodier-Kette folgt die Reed-Solomon Decodierung mit einer RS-Coderate von 112/126 = 8/9.

Teilerfaktoren RS:

$$L_{RS} = 8 \; ; M_{RS} = 9$$

Als letzter Schritt erfolgt schließlich das Deframing auf der Empfangsseite mit einer ESC-Umsetzrate, die sich für einen IBS-Rahmen zu 15/16 ergibt.

Teilerfaktoren ESC:

$$L_{ESC} = 15 \; ; M_{ESC} = 16$$

Damit ergibt sich für das Umsetzverhältnis von der doppelten Symbolrate DSR zu der Inforate IR am Ausgang der Deframing-Einheit:

$$IR/DSR = (L_{SYNC}/M_{SYNC})*(L_{FEC}/M_{FEC})*(L_{RS}/M_{RS})*(L_{ESC}/M_{ESC})$$

$$IR/DSR = (1/2) * (3/2) * (8/9) * (15/16)$$

Nach weitest möglicher Kürzung gemeinsamer Teiler ergibt sich schließlich:

$$IR/DSR = 5/8 \qquad d.h. \; L_{IR} = 5 \; ; M_{IR} = 8$$

In diesem speziellen Fall ergeben sich vergleichsweise kleine Teilerfaktoren. Dies liegt am vorgegebenen RS-Code, der für sämtliche kleineren Inforaten mit der Coderate 8/9 vorgegeben ist.

Für das Umsetzverhältnis von DSR zu der Compositerate CR ergibt sich:

$$CR/DSR = (L_{SYNC}/M_{SYNC}) * (L_{FEC}/M_{FEC}) * (L_{RS}/M_{RS})$$

Nach weitest möglicher Kürzung gemeinsamer Teiler ergibt sich hier:

$$CR/DSR = 2/3 \qquad d.h. \; L_{CR} = 2 \; ; M_{CR} = 3$$

Schließlich ergibt sich für das Umsetzverhältnis von DSR zu der Coded Compositerate CCR:

$$CCR/DSR = (L_{SYNC}/M_{SYNC}) * (L_{FEC}/M_{FEC})$$

$$CCR/DSR = 3/4 \qquad d.h.\ L_{CCR} = 3\ ;\ M_{CCR} = 4$$

Das kleinste, gemeinsame Vielfache der Nenner M bei sämtlichen, umzusetzenden Taktraten liegt mit M = 24 vor. Die drei Umsetzverhältnisse können entsprechend erweitert werden, so daß der Nenner jeweils identisch zu M = 24 ist. Damit ergibt sich:

$$IR/DSR = 5/8 = 15/24$$

$$CR/DSR = 2/3 = 16/24$$

$$CCR/DSR = 3/4 = 18/24$$

Werden die drei Phaseninkremente $i_{nom}$, $i_{+\varepsilon}$ und $i_{-\varepsilon}$ so optimiert, d.h. modifiziert, daß alle durch den Nenner M = 24 teilbar sind, ergeben sich einerseits die optimierten Phaseninkremente $i_{nom,opt}$, $i_{+\varepsilon,opt}$ und $i_{-\varepsilon,opt}$, andererseits ist damit auch die Bedingung $R_{nom} = R_{+\varepsilon} = R_{-\varepsilon} = 0$ erfüllt.
Konkret heißt das im vorliegenden Beispiel:

$$i_{nom} = 137\ 439 >> i_{nom,opt} = 137\ 448$$

$$i_{+\varepsilon} = 138\ 126 >> i_{+\varepsilon,opt} = 138\ 120$$

$$i_{-\varepsilon} = 136\ 752 >> i_{-\varepsilon,opt} = 136\ 752$$

Anstelle der ursprünglich vorgegebenen Abweichung E von $\pm0,5\%$ ergeben sich aus den optimierten Inkrementen $i_{nom,opt}$, $i_{+\varepsilon,opt}$ und $i_{-\varepsilon,opt}$ folgende Abweichungen:

$$\varepsilon_{+} = +0,5\% >> \varepsilon_{+,opt} = +0,489\%$$

$$\varepsilon_{-} = -0,5\% >> \varepsilon_{-,opt} = -0,506\%$$

Hierbei hat sich auch der Nominalwert $i_{nom,opt}$ gegenüber $i_{nom}$ um eine Abweichung $\delta$ von $\delta = +0,0065\%$ verschoben.
Der Vollständigkeit halber sollen im folgenden jeweils die drei Phaseninkremente für die einzelnen Taktumsetzungen angegeben werden:

| | | |
|---|---|---|
| CCR | CCR/DSR | = 18/24 |
| | $i_{CCR,nom,opt}$ | = 103 086 |
| | $i_{CCR,+\varepsilon,opt}$ | = 103 590 |
| | $i_{CCR,+\varepsilon,opt}$ | = 102 564 |
| CR | CR/DSR | = 16/24 |
| | $i_{CR,nom,opt}$ | = 91 632 |
| | $i_{CR,+\varepsilon,opt}$ | = 92 080 |
| | $i_{CR,-\varepsilon,opt}$ | = 91 168 |
| IR | IR/DSR | = 15/24 |

(fortgesetzt)

| | |
|---|---|
| $i_{IR,nom,opt}$ | = 85 905 |
| $i_{IR,+\varepsilon,opt}$ | = 86 325 |
| $i_{IR,-\varepsilon,opt}$ | = 85 470 |

Ein weiteres Beispiel soll die Anwendung des Konzeptes der virtuellen PLL auf die Sendeseite (Fig. 1) darlegen.

Beispiel 5: (b=24bit; wie Beispiel 4, jedoch Sendeseite)

Annahmen:

| | |
|---|---|
| Abtastrate SAR | SAR = 12,5 MHz (Ausgang COVADI!) |
| Inforate IR | IR = 64 kHz (Kleinste Inforate USM9000!) |
| Compositerate CR | CR=68,266..kHz (Overhead IBS: OR=1/15*IR) |
| Coded Compositerate | CCR = 76,8 kHz (RS-Coderate: 112/126) |
| Symbolrate SR | SR = 51,2 kHz (FEC-Rate: 3/4; QPSK-Mod.) |
| Symbolrate SR | SR = 51,2 kHz (Eingang COVADI!) |

Bei den obigen Annahmen ergibt sich ein nominaler Dezimationsfaktor $d_{nom}$ von:

$$d_{nom} = SAR/SR = 244,140625$$

Hieraus ergibt sich ein Nominalwert $i_{nom}$ für das Phaseninkrement zur Erzeugung der Symbolrate SR von (Annahme: b = 24 bit):

$$i_{nom} = 2^b * (d_{nom})^{-1} = 0,004096 * 2^{24} = 68\ 719,47674$$

Bei einer angenommenen Abweichung E von $\pm0,5\%$ ergeben sich die Inkremente $i_{+\varepsilon}$ und $i_{-\varepsilon}$ zu:

$$i_{+\varepsilon} = i_{nom}(1 + \varepsilon) = 0,00411648 * 2^{24} = 69\ 063,07412$$

und:

$$i_{-\varepsilon} = i_{nom}(1 - \varepsilon) = 0,00407552 * 2^{24} = 68\ 375,87935$$

Nach einer Quantisierung auf ganze Zahlen ergibt sich schließlich:

$i_{nom} = 68\ 719$
$i_{+\varepsilon} = 69\ 063$
$i_{-\varepsilon} = 68\ 376$

Diese drei Werte ergeben sich zunächst ohne Berücksichtigung einer zu realisierenden Taktumsetzung mit Hilfe des aufwandsoptimierten Konzeptes der virtuellen PLL.
Bei einem verkettet codierten System, wie in diesem Beispiel angenommen, ergeben sich die Teilerfaktoren einer PLL multiplikativ aus den einzelnen Umsetzfaktoren. Konkret heißt dies im vorliegenden Beispiel:
Ausgangspunkt ist die Symbolrate SR am Eingang des COVADI-Bausteins. Eine erste Umsetzung erfolgt innerhalb des Faltungs-Encoders, an dem eine FEC-Rate 3/4 vorliegt und außerdem zu berücksichtigen ist, daß QPSK-Modulation vorliegt und somit 2 bit pro Symbol übertragen werden.

$$(L_{FEC}/M_{FEC} = 3/4 * 2/1 = 3/2)$$

Teilerfaktoren FEC:

$$L_{FEC} = 3 \; ; \; M_{FEC} = 2$$

In der Encodier-Kette folgt die Reed-Solomon Encodierung mit einer RS-Coderate von 112/126 = 8/9.
Teilerfaktoren RS:

$$L_{RS} = 8 \; ; \; M_{RS} = 9$$

Als letzter Schritt hin zur Eingangsschnittstelle erfolgt schließlich das Framing auf der Sendeseite mit einer ESC-Umsetzrate, die sich für einen IBS-Rahmen zu 15/16 ergibt.
Teilerfaktoren ESC:

$$L_{ESC} = 15 \; ; \; M_{ESC} = 16$$

Damit ergibt sich für das Umsetzverhältnis von der Symbolrate SR zu der Inforate IR am Eingang der Framing-Einheit:

$$IR/SR = (L_{FEC}/M_{FEC}) * (L_{RS}/M_{RS}) * (L_{ESC}/M_{ESC})$$

$$IR/SR = (3/2) * (8/9) * (15/16)$$

Nach weitest möglicher Kürzung gemeinsamer Teiler ergibt sich schließlich:

$$IR/SR = 5/4 \qquad \text{d.h.} \; L_{IR} = 5 \; ; \; M_{IR} = 4$$

In diesem speziellen Fall ergeben sich vergleichsweise kleine Teilerfaktoren. Dies liegt am vorgegebenen RS-Code, der für sämtliche kleineren Inforaten mit der Coderate 8/9 vorgegeben ist.
Für das Umsetzverhältnis von SR zu der Compositerate CR ergibt sich:

$$CR/SR = (L_{FEC}/M_{FEC}) * (L_{RS}/M_{RS})$$

Nach weitest möglicher Kürzung gemeinsamer Teiler ergibt sich hier:

$$CR/SR = 4/3 \; \text{d.h.} \; L_{CR} = 4 \; ; \; M_{CR} = 3$$

Schließlich ergibt sich für das Umsetzverhältnis von SR zu der Coded Compositerate CCR:

$$CCR/SR = (L_{FEC}/M_{FEC})$$

$$CCR/SR = 3/2 \; \text{d.h.} \; L_{CCR} = 3 \; ; \; M_{CCR} = 2$$

Das kleinste, gemeinsame Vielfache der Nenner M bei sämtlichen, umzusetzenden Taktraten liegt mit M = 12 vor. Die drei Umsetzverhältnisse können entsprechend erweitert werden, so daß der Nenner jeweils identisch zu M = 12 ist. Damit ergibt sich:

$$IR/SR = 5/4 = 15/12$$

$$CR/SR = 4/3 = 16/12$$

$$CCR/SR = 3/2 = 18/12$$

Werden die drei Phaseninkremente $i_{nom}$, $i_{+\varepsilon}$ und $i_{-\varepsilon}$ so optimiert, d.h. modifiziert, daß alle durch den Nenner M = 12 teilbar sind, ergeben sich einerseits die optimierten Phaseninkremente $i_{nom,opt}$, $i_{+\varepsilon,opt}$ und $i_{-\varepsilon,opt}$, andererseits ist damit auch die Bedingung $R_{nom} = R_{+\varepsilon} = R_{-\varepsilon} = 0$ erfüllt.

Konkret heißt das im vorliegenden Beispiel:

$$i_{nom} = 68\ 719 >> i_{nom,opt} = 68\ 724$$

$$i_{+\varepsilon} = 69\ 063 >> i_{+\varepsilon,opt} = 69\ 060$$

$$i_{-\varepsilon} = 68\ 376 >> i_{-\varepsilon,opt} = 68\ 376$$

Anstelle der ursprünglich vorgegebenen Abweichung $\varepsilon$ von $\pm0,5\%$ ergeben sich aus den optimierten Inkrementen $i_{nom,opt}$, $i_{+\varepsilon,opt}$ und $i_{-\varepsilon,opt}$ folgende Abweichungen:

$$\varepsilon_+ = +0,5\% >> \varepsilon_{+,opt} = +0,489\%$$

$$\varepsilon_- = -0,5\% >> \varepsilon_{-,opt} = -0,506\%$$

Hierbei hat sich auch der Nominalwert $i_{nom,opt}$ gegenüber $i_{nom}$ um eine Abweichung $\delta$ von $\delta = +0,0073\%$ verschoben.

Der Vollständigkeit halber sollen im folgenden jeweils die drei Phaseninkremente für die einzelnen Taktumsetzungen angegeben werden:

| CCR | CCR/SR | = 18/12 |
|-----|--------|---------|
| | $i_{CCR,nom,opt}$ | = 103 086 |
| | $i_{CCR,+\varepsilon,opt}$ | = 103 590 |
| | $i_{CCR,-\varepsilon,opt}$ | = 102 564 |
| CR | CR/DSR | = 16/12 |
| | $i_{CR,nom,opt}$ | = 91 632 |
| | $i_{CR,+\varepsilon,opt}$ | = 92 080 |
| | $i_{CR,-\varepsilon,opt}$ | = 91 168 |
| IR | IR/DSR | = 15/12 |
| | $i_{IR,nom,opt}$ | = 85 905 |
| | $i_{IR,+\varepsilon,opt}$ | = 86 325 |
| | $i_{IR,-\varepsilon,opt}$ | = 85 470 |

Die Beispiele 1 bis 5 zeigen, daß für verschiedene Taktfrequenzkombinationen Phaseninkremente mit ausreichender Genauigkeit berechnet werden können. Außerdem zeigen die Beispiele, daß eine Wortbreite b von b = 24 bit in vielen Fällen ausreichend ist.

Fig. 2 zeigt den empfängerseitigen Teil eines Modems mit einer Einrichtung zur erfindungsgemäßen Taktableitung. Einem Eingang 31 wird das empfangene Signal zugeleitet. Das demodulierte und decodierte Signal kann einem Ausgang 32 entnommen werden. Das empfangene Signal wird nach Analog-Digital-Wandlung bei 33 über ein Filter 34 geleitet und gelangt zur Synchronisierschaltung 35. Diese Schaltungen werden mit einem bei 30 zugeführten Abtasttakt SAR betrieben. In der Synchronisierschaltung 35 wird aus dem empfangenen Signal ein Symboltakt SR abgeleitet, der einer Phasenvergleichsschaltung 41 zugeführt wird.

Nach der Synchronisierschaltung 35 durchläuft das empfangene Signal einen FIFO-Speicher 36, zwei Decoder 37, 38, eine Deframing-Schaltung 39 sowie eine Ausgangsschaltung 40. Zur Bildung der Taktsignale CCR, CR und IR sowie eines mit dem Symboltakt SR zu vergleichenden Taktsignals SR' sind vier Akkumulatoren vorgesehen, die jeweils aus einem Register 42, 43, 44, 45 und einem Addierer 46, 47, 48, 49 bestehen. Jeweils drei Phaseninkremente sind in je einem Speicher 50, 51, 52, 53 abgelegt. Welches der drei Phaseninkremente aus dem Speicher 50 bis 53 ausgelesen und dem jeweiligen Addierer 46 bis 49 zugeführt wird, wird vom Signal SEL bestimmt, das aus dem Ergebnis des Phasenvergleichs bei 41 mit Hilfe eines Tiefpaßfilters 54 abgeleitet wird.

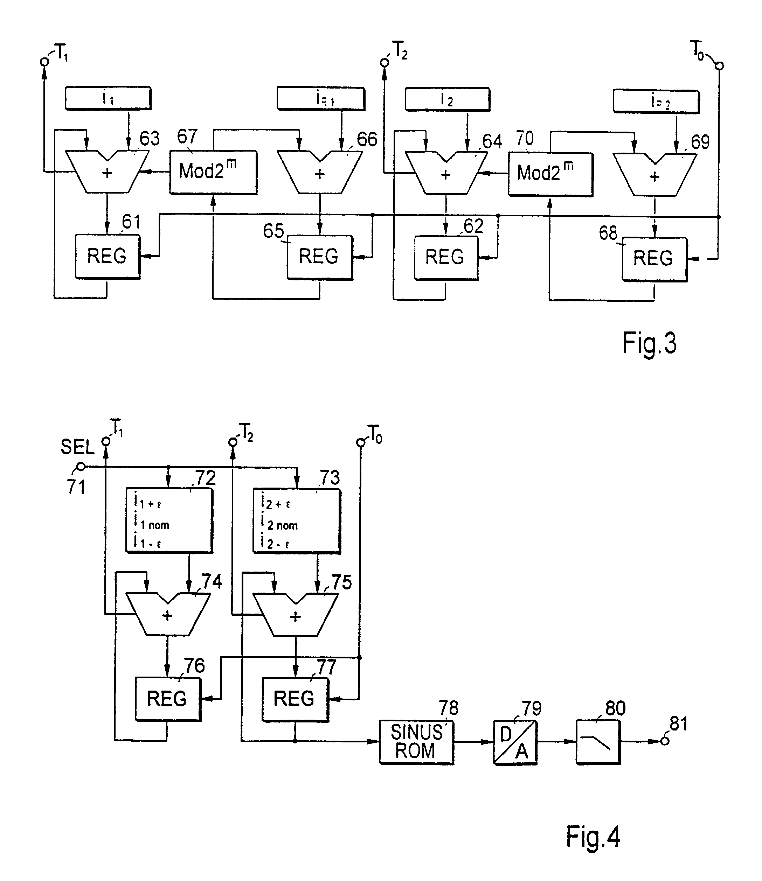

Fig. 3 zeigt eine weitere Möglichkeit zur Vermeidung einer Fehlerfortpflanzung. Mit Hilfe der in Fig. 3 dargestellten Schaltungsanordnung werden aus einem Takt $T_0$ zwei Takte $T_1$ und $T_2$ abgeleitet, wozu der Inhalt zweier Akkumulatoren, die jeweils aus einem Register 61, 62 und einem Addierer 63, 64 bestehen, mit jedem Takt $T_0$ um ein Phaseninkrement $i_1$ bzw. $i_2$ inkrementiert wird. Die Phaseninkremente $i_1$ und $i_2$ im Verhältnis zur Akkumulator-Kapazität bestimmen das Frequenzverhältnis der abgeleiteten Takte $T_1$ und $T_2$ zum zugeführten Takt $T_0$, wobei das Verhältnis der Kapazität des jeweiligen Registers zum jeweiligen Phaseninkrement nicht ganzzahlig ist. Eine Fehlerfortpflanzung wird bei der Anordnung nach Fig. 3 dadurch verhindert, daß synchron mit den Akkumulatoren 61, 63 bzw. 62, 64 jeweils ein weiterer Akkumulator 65, 66 bzw. 68, 69 von dem Takt $T_0$ getaktet wird, der einen Restfehler $i_{R,1}$ bzw. $i_{R,2}$ akkumuliert. Von dem jeweiligen Akkumulatorinhalt wird das Modulo$2^m$ bei 67 bzw. 70 gebildet und dem jeweiligen Addierer 63 bzw. 64 als Übertrag zugeführt.

Die Anordnung nach Fig. 4 dient ebenfalls dazu, zwei Taktsignale $T_1$ und $T_2$ aus dem zugeführten Taktsignal $T_0$ abzuleiten. Zur Vermeidung der Fehlerfortpflanzung wird in Abhängigkeit eines bei 71 zugeführten Signals SEL eines von jeweils drei in Speichern 72, 73 abgelegten Phaseninkrementen je einem Addierer 74, 75 zugeführt. In je einem Register 76, 77 wird der jeweils akkumulierte Wert gespeichert. Im Falle des Taktsignals $T_2$ wird der Registerinhalt zusätzlich einem Sinus-ROM 78 zugeleitet, aus dem entsprechend den zugeführten Werten ein digitales Sinussignal auslesbar ist. Dieses wird über einen Digital/Analog-Wandler 79 einem Anti-Aliasing-Filter 80 zugeleitet, an dessen Ausgang 81 ein jitterfreies Sinussignal ansteht, aus dem durch Nulldurchgangsdetektion ein jitterfreies Taktsignal abgeleitet werden kann.

## Patentansprüche

1. Verfahren zur Ableitung von mehreren Taktsignalen für Signalverarbeitungsschaltungen, insbesondere für ein digitales Modem, aus einem zugeführten Taktsignal, mit folgenden Merkmalen:
   Die abzuleitenden Taktsignale werden jeweils von einem Ausgangssignal eines Akkumulators vorgegebener Bitbreite n gebildet, der jeweils ein gespeichertes Datenwort im Takt des zugeführten Taktsignals akkumuliert und hierbei eine Modulo$2^n$-Operation ausführt,

   - es wird ein zweites Taktsignal zugeführt und das gespeicherte Datenwort in Abhängigkeit von der Phasenlage des zweiten zugeführten Taktsignals in bezug auf eines der abzuleitenden Taktsignale verändert,

   - für das gespeicherte Datenwort sind jeweils mehrere vorgegebene Werte, insbesondere drei, in einem Speicher abgelegt, von denen einer als zu akkumulierendes gespeichertes Datenwort in Abhängigkeit von der Phasenlage ausgewählt wird.

   - ein weiterer Akkumulator mit einer vorgegebenen Bitbreite m und einem darstellbaren Zahlenbereich von Z ist Element von $[2^m-1,0]$ akkumuliert Restwerte im Takt des ersten zugeführten Taktsignals,

   - der jeweilige Inhalt des weiteren Akkumulators wird nach Modulo$2^m$-Bildung einem Übertrageintrag des Akkumulators für das jeweils abzuleitende Taktsignal zugeführt, wobei m und n natürliche Zahlen sind.

2. Verfahren zur Ableitung von mehreren Taktsignalen für Signalverarbeitungsschaltungen, insbesondere für ein digitales Modem, aus einem zugeführten Taktsignal, mit folgenden Merkmalen: Die abzuleitenden Taktsignale werden jeweils von einem Ausgangssignal eines Akkumulators vorgegebener Bitbreite n gebildet, der jeweils ein gespeichertes Datenwort im Takt des zugeführten Taktsignals akkumuliert und hierbei eine Modulo$2^n$-Operation ausführt,

   - es wird ein zweites Taktsignal zugeführt und das gespeicherte Datenwort in Abhängigkeit von der Phasenlage des zweiten zugeführten Taktsignals in bezug auf eines der abzuleitenden Taktsignale verändert,

- für das gespeicherte Datenwort sind jeweils mehrere vorgegebene Werte, insbesondere drei, in einem Speicher abgelegt, von denen einer als zu akkumulierendes gespeichertes Datenwort in Abhängigkeit von der Phasenlage ausgewählt wird,
- die gespeicherten Datenworte werden so gewählt, daß das jeweils dem Akkumulator zugeführte gespeicherte Datenwort restfrei in dem durch die vorgegebene Bitbreite darstellbaren Zahlenbereich durch den größten gemeinsamen Teiler aller zu realisierenden Taktumsetzverhältnisse teilbar ist.

## Claims

1. Method for deriving a plurality of clock signals for signal-processing circuits, in particular for a digital modem, from a supplied clock signal, having the following features:

   - the derived clock signals are formed in each case from an output signal of an accumulator of prescribed bit width n, which in each case accumulates a stored data word in time with the supplied clock signal, and in the process executes a modulo$2^n$ operation,
   - a second clock signal is supplied, and the stored data word is varied as a function of the phase angle of the second supplied clock signal with reference to one of the clock signals to be derived,
   - for the stored data word there are respectively stored in a memory a plurality of prescribed values, in particular three, of which one is selected as a function of the phase angle as a stored data word to be accumulated,
   - a further accumulator, with a prescribed bit width m and a displayable numerical range of Z, Z is an element of $[2^m-1,0]$, accumulates residual values in time with the first supplied clock signal, and
   - after modulo$2^m$ formation, the respective contents of the further accumulator are supplied to a carry entry of the accumulator for the clock signal respectively to be derived, m and n being natural numbers.

2. Method for deriving a plurality of clock signals for signal-processing circuits, in particular for a digital modem, from a supplied clock signal, having the following features:

   - the derived clock signals are formed in each case from an output signal of an accumulator of prescribed bit width n, which in each case accumulates a stored data word in time with the supplied clock signal, and in the process executes a modulo$2^n$ operation,
   - a second clock signal is supplied, and the stored data word is varied as a function of the phase angle of the second supplied clock signal with reference to one of the clock signals to be derived,
   - for the stored data word there are respectively stored in a memory a plurality of prescribed values, in particular three, of which one is selected as a function of the phase angle as a stored data word to be accumulated, and
   - the stored data words are selected such that the stored data word respectively supplied to one accumulator can be divided without remainder in the numerical range displayable by the prescribed bit width by the greatest common divisor of all the clock rate conversion ratios to be realized.

## Revendications

1. Procédé pour dériver plusieurs signaux de cadence (signaux d'horloge) destinés à des circuits de traitement de signal, notamment un Modem numérique à partir d'un signal d'horloge appliqué en entrée et ayant les caractéristiques suivantes :

   - les signaux de cadence à dériver sont formés chaque fois d'un signal de sortie d'un accumulateur avec une largeur de bit (n) prédéterminée, qui accumule chaque fois un mot de données mémorisé en cadence du signal de cadence appliqué et effectue une opération modulo $2^n$.
   - on applique un second signal d'horloge et on modifie le mot de données mémorisé en fonction de la phase du second signal d'horloge appliqué par rapport à un signal d'horloge à dériver,
   - pour le mot de données mémorisé, on a chaque fois plusieurs valeurs prédéterminées, notamment trois valeurs enregistrées dans une mémoire et parmi lesquelles une valeur est sélectionnée comme mot de données mémorisée à accumuler en fonction de la phase,
   - un autre accumulateur avec une largeur de bit prédéterminée (m) et une plage de nombres à représenter de Z est un élément de $[2^m-1,01]$, valeurs résiduelles accumulées, en cadence du premier signal de cadence appliqué,

- le contenu respectif de l'autre accumulateur est appliqué après une opération modulo $2^m$ à une entrée de transfert de l'accumulateur pour le signal de cadence à dériver à chaque fois,
- (m) et (n) étant des nombres naturels.

2. Procédé pour dériver plusieurs signaux de cadence (signaux d'horloge) destinés à des circuits de traitement de signaux notamment à un Modem numérique à partir d'un signal d'horloge appliqué ayant les caractéristiques suivantes :

- les signaux de cadence à dérivés sont formés à partir d'un signal de sortie d'un accumulateur ayant une largeur de bit (n), qui accumule un mot de données mémorisé à la cadence du signal de cadence appliqué et effectue ainsi une opération modulo $2^m$,
- on applique un second signal de cadence et le mot de données mémorisé est modifié en fonction de la phase du second signal de cadence appliqué par rapport aux signaux de cadence à dériver,
- pour le mot de données mémorisé, on a chaque fois plusieurs valeurs prédéterminées, notamment trois valeurs enregistrées dans une mémoire parmi lesquelles, une valeur est sélectionnée comme mot de données mémorisé, qu'il faut accumuler en fonction de la phase,
- on choisit les mots de données mémorisés pour que le mot de données enregistré, chaque fois appliqué à l'accumulateur, ne comporte pas de résidu dans la plage des nombres à représenter par la largeur de bit prédéterminée, et puissent être divisés par le plus grand diviseur commun pour tous les rapports de conversion de cadence à réaliser.

Fig.1

EP 0 885 487 B1

Fig.2

EP 0 885 487 B1

Fig.3

Fig.4